# EUROPÄISCHE PATENTSCHRIFT

(11) **EP 1 625 663 B1**
(45) Veröffentlichungstag und Bekanntmachung des Hinweises auf die Patenterteilung: **22.03.2017**
(21) Anmeldenummer: 04727877.5
(22) Anmeldetag: 16.04.2004
(51) Int. Cl.: H03K 19/173

(54) **INTEGRIERTE SCHALTUNGSANORDNUNG UND VERFAHREN ZUR PROGRAMMIERUNG EINER INTEGRIERTEN SCHALTUNGSANORDNUNG**
INTEGRATED CIRCUIT ARRANGEMENT, AND METHOD FOR PROGRAMMING AN INTEGRATED CIRCUIT ARRANGEMENT
CIRCUIT INTEGRE ET PROCEDE DE PROGRAMMATION D'UN CIRCUIT INTEGRE

(30) Priorität: 21.05.2003 DE 10323012
(43) Veröffentlichungstag der Anmeldung: 15.02.2006
(73) Patentinhaber: ams AG, 8141 Unterpremstätten (AT)
(72) Erfinder: BÜHLER, Tobias, A-8010 Graz (AT); HAIPLIK, Holger, Swindon, SN56EQ (GB); JESSENIG, Thomas, A-8054 Attendorf (AT); LUEGER, Manfred, A-8504 Stainz (AT)
(74) Vertreter: Epping - Hermann - Fischer
(86) Internationale Anmeldenummer: PCT/EP2004/004079
(87) Internationale Veröffentlichungsnummer: WO 2004/105246

(56) Entgegenhaltungen:
- EP-A- 1 355 426
- US-A- 5 157 397
- US-A- 5 608 341
- US-B1- 6 351 175

## Beschreibung

Die vorliegende Erfindung betrifft eine integrierte Schaltungsanordnung sowie ein Verfahren zur Programmierung einer integrierten Schaltungsanordnung.

Herkömmliche integrierte Schaltkreise können nach dem Ende der Fertigung lediglich in einer Betriebsart betrieben werden, für die sie vorgesehen sind.

Es kann aber wünschenswert sein, den gleichen integrierten Baustein für mehrere, unterschiedliche Anwendungsfälle geeignet zu halten und die jeweils vorgesehene Betriebsart erst nach dem Ende der Herstellung desselben auszuwählen, beispielsweise auch erst nach dem Vergießen oder Umhäusen eines Chips.

Es kann weiterhin wünschenswert sein, die Spannungswerte der Versorgungsspannungen einzelner Funktionsblöcke, eine Auswahl bestimmter Funktionsblöcke oder eine Reihenfolge des Einschaltens bestimmter Funktionsblöcke bzw. deren Initialisierung festzulegen, beispielsweise im Rahmen einer sogenannten Start-Up-Sequenz.

Die beschriebene Programmierung eines integrierten Bauteils könnte beispielsweise durch Fuse-Bänke, DIP-Schalter oder ähnliches nachträglich festgelegt werden.

Alle derartigen, bekannten Maßnahmen sind jedoch mit einem verhältnismäßig großen Aufwand verbunden. Dieser unerwünschte Aufwand kann beispielsweise durch einen erhöhten Flächenbedarf auf einer Platine bedingt sein oder durch eine Vielzahl notwendiger, zusätzlicher Anschlußbeinchen (Pins) am Chip.

Das Dokument US 6,351,175 B1 betrifft eine Betriebsartauswahlschaltung. Ein Betriebsartauswahlanschluß wird wahlweise mit einem Konfigurationselement verbunden, um den Betriebsartauswahlanschluß auf eine von mehreren vorbestimmten Spannungen vorzuspannen. Ein Spannungsteiler stellt mehrere Spannungen bereit.

Aufgabe der vorliegenden Erfindung ist es, eine integrierte Schaltungsanordnung zu schaffen, welche nach dem Ende der Herstellung mit geringem Aufwand programmiert, das heißt in eine gewünschte Betriebsart versetzt werden kann. Eine weitere Aufgabe der Erfindung ist es, ein Verfahren zur Programmierung einer integrierten Schaltungsanordnung anzugeben, welches mit geringem Aufwand durchgeführt werden kann und den Betrieb der integrierten Schaltungsanordnung in einer nach Ende der Fertigung auswählbaren Betriebsart ermöglicht.

Erfindungsgemäß wird die Aufgabe bezüglich der integrierten Schaltungsanordnung gelöst durch eine integrierte Schaltungsanordnung mit den Merkmalen des Patentanspruchs 1.

Bei dem vorgeschlagenen Prinzip erfolgt die Programmierung, beispielsweise die Wahl einer von mehreren vorbestimmten Betriebsarten, der integrierten Schaltungsanordnung dadurch, daß an den Anschluß der integrierten Schaltungsanordnung ein externes, auslesbares Bauteil angeschlossen wird. Dieses Bauteil hat einen auslesbaren Wert, beispielsweise einen bestimmten Widerstandswert, der mit einem Referenzwert eines Referenzbauteils verglichen wird. In Abhängigkeit vom Vergleichsergebnis wird die integrierte Schaltungsanordnung mittels der Steuereinheit in eine bestimmte Betriebsart versetzt, das heißt programmiert.

Das externe, auslesbare Bauteil ist bevorzugt ein passives Bauteil.

Durch Wahl des Wertes des am Anschluß der integrierten Schaltungsanordnung angeschlossenen externen Bauteils kann unter einer praktisch beliebig großen Zahl unterschiedlicher, vorbestimmter Programmierungen ausgewählt werden.

Das beschriebene Prinzip erfordert lediglich ein zusätzliches Pin, das heißt Anschlußbeinchen an einer integrierten Schaltungsanordnung. Dadurch kann die Programmierung der integrierten Schaltungsanordnung mit besonders geringem Aufwand erfolgen.

Zum Auslesen des externen, passiven Bauteils ist b eine Signalquelle beispielsweise in der integrierten Schaltungsanordnung vorgesehen, die ein Referenzsignal erzeugt, mit dem das externe, auslesbare Bauteil beaufschlagt wird.

Der weitere Anschluß des externen, auslesbaren Bauteils ist bevorzugt mit einem Bezugspotentialanschluß, beispielsweise Masse, verbindbar.

Der Vergleicher, der den Wert des externen, auslesbaren Bauteils mit dem Wert des Referenzbauteils vergleicht, umfaßt bevorzugt einen Analog/Digital-Wandler zur Abgabe des Vergleichsergebnisses in digitaler Form.

Beispielsweise kann ein A/D-Wandler mit einer Auflösung von 3 Bit vorgesehen sein, so daß insgesamt 8 verschiedene Betriebszustände durch einfache Wahl des Wertes des anzuschließenden auslesbaren Bauteils aktiviert werden können.

Der Analog/Digital-Wandler hat gemäß einer bevorzugten Weiterbildung der Schaltungsanordnung eine logarithmische Kennlinie. Dadurch sind die Anforderungen an die Toleranz des externen, auslesbaren Bauteils sowie an die Toleranzen bei der Weiterverarbeitung des ausgelesenen Wertes deutlich reduziert. Beispielsweise kann ein externes auslesbares Bauteil mit einer Toleranz von 30 % aufgrund der logarithmischen Kennlinie dennoch zuverlässig ausgelesen werden und zuverlässig eine von mehreren vorbestimmten Betriebsarten selektieren.

Das Referenzbauteil kann als extern anschließbares Bauteil oder als auf der Schaltungsanordnung integriertes Bauteil vorgesehen sein.

Bei integrierten Schaltungsanordnungen ist zur Erzeugung von hochgenauen Referenzsignalen, beispielsweise von Bias-Strömen, ohnehin oftmals ein externes Referenzbauteil vorgesehen, welches an einem Anschlußbeinchen (Pin) der integrierten Schaltungsanordnung angeschlossen ist. Dies kann beispielsweise ein externer Filter-Kondensator sein. Dieses Bauteil wird zugleich als Referenzbauteil für die Programmierung der integrierten Schaltungsanordnung gemäß dem vorgeschlagenen Prinzip mit verwendet. Zum Ermitteln des Vergleichsergebnisses wird dabei auch das externe Referenzbauteil mit dem von der Signalquelle abgegebenen Referenzsignal beaufschlagt und der Wert des Referenzbauteils ausgelesen.

Ein externes Referenzbauteil hat geringere Toleranzen als ein integriertes Referenzbauteil.

Die Ausführung des Referenzbauteils als integriertes Bauteil hingegen ist insbesondere dann vorteilhaft, wenn nicht ohnehin ein externes Referenzbauteil zur Funktionsfähigkeit der integrierten Schaltung nötig ist und/oder eine besonders geringe Pin-Anzahl der Schaltungsanordnung gefordert ist.

Das Referenzbauteil und das auslesbare, programmierende Bauteil sind als Kondensator ausgebildet.

Die integrierte Schaltungsanordnung kann mehrere Funktionsblöcke umfassen, wobei die Steuereinheit abhängig vom Vergleichsergebnis des Vergleichers diese Funktionsblöcke mit unterschiedlicher Versorgungsspannung, Referenzspannung und/oder Einschaltreihenfolge ansteuern kann.

Zwischen den Ausgang des Vergleichers und die Steuereinheit ist bevorzugt ein flüchtiger Speicher geschaltet, ein sogenanntes Latch, zum Zwischenspeichern des Vergleichsergebnisses des Vergleichers.

Das Auslesen des auslesbaren Wertes des externen, auslesbaren Bauteils und der Vergleich dieses Wertes mit dem Wert des Referenzbauteils erfolgt bevorzugt während einer Einschaltphase der integrierten Schaltungsanordnung. Um das Vergleichsergebnis während der gesamten Betriebszeit der integrierten Schaltungsanordnung verfügbar zu haben, ist es vorteilhaft, dieses zwischenzuspeichern.

Um die Vielzahl vorbestimmter Betriebsarten zu definieren, von denen jeweils eine durch Wahl des Wertes des externen auslesbaren Bauteils festgelegt werden kann, ist bevorzugt ein Speicherblock vorgesehen zum Ablegen von Steuerungsparametern für die jeweiligen Betriebsarten. Dieser Speicherblock ist so mit der Steuereinheit gekoppelt, daß in Abhängigkeit von dem Vergleichsergebnis des Vergleichers eine der gespeicherten Betriebsarten aktiviert wird.

Der Speicherblock ist bevorzugt als sogenanntes Boot-ROM (Read Only Memory) ausgeführt und wird beim Einschalten der integrierten Schaltungsanordnung ausgelesen.

Um zusätzliche Flexibilität zu gewinnen, kann das Boot-ROM programmierbar ausgeführt sein, beispielsweise durch Wahl der Masken für die Metallisierungsebenen des programmierbaren Boot-ROMs bei der Fertigung.

Das beschriebene Prinzip ist bevorzugt bei sogenannten PowerManagement-Units, PMU anwendbar, um die Einschaltreihenfolge, englisch: power-on-sequence, zu steuern. Die verschiedenen, vorbestimmbaren Sequenzen können in dem ROM abgelegt und definiert werden und werden in der Anwendung durch den Wert des programmierenden, auslesbaren Bauteils ausgewählt.

Eine noch weitere Vergrößerung der Flexibilität wird erhalten, indem ein programmierbares ROM mit sogenannten Zeneroder Poly-Fuses, also programmierbaren Verbindungen vorgesehen ist anstelle des Metall-Masken programmierbaren ROMs. Bei derartigen sogenannten Fuses oder Antifuses wird der Leitfähigkeitszustand der Fuse durch Beaufschlagen mit einem Energieimpuls festgelegt, wobei der Leitfähigkeitszustand zwischen hochohmig und niederohmig umgeschaltet werden kann.

Wenn das Referenzbauteil als integriertes Bauteil vorgesehen ist, so kann es vorteilhaft sein, die Genauigkeit durch eine einfache Abgleichmöglichkeit des integrierten Referenzbauteils zu erhöhen.

Um die Signalquelle und den Vergleicher nach einem Einschalten der integrierten Schaltungsanordnung zu aktivieren, kann es vorteilhaft sein, einen Aktivierungsschaltkreis vorzusehen, der mit jeweiligen Aktivierungseingängen von Vergleicher und/oder Signalquelle gekoppelt ist. Der Aktivierungsschaltkreis ist ausgelegt zum Aktivieren des Vergleichers und gegebenenfalls der Signalquelle nach dem Einschalten des integrierten Schaltkreises und schaltet diese wieder ab, sobald der Vergleich, gegebenenfalls mit Analog/Digital-Wandlung, beendet und das Vergleichsergebnis abgespeichert ist.

Bezüglich des Verfahrens wird die Aufgabe gelöst durch ein Verfahren zur Programmierung einer integrierten Schaltungsanordnung, umfassend die Verfahrensschritte des Patentanspruchs 11.

Gemäß dem vorgeschlagenen Verfahren wird an die integrierte Schaltungsanordnung ein externes, auslesbares Bauteil angeschlossen und anschließend der Wert dieses externen auslesbaren Bauteils ausgelesen. Dieser Wert wird anschließend mit dem ebenfalls ausgelesenen Wert eines Referenzbauteils, also einem Referenzwert verglichen und es wird ein Vergleichsergebnis ermittelt. In Abhängigkeit von diesem Vergleichsergebnis wird ein Auswahlsignal abgegeben zur Steuerung des integrierten Schaltkreises.

Dabei wird in Abhängigkeit vom Auswahlsignal die integrierte Schaltungsanordnung in einem von mehreren vorbestimmten Betriebszuständen versetzt.

Der Referenzwert wird durch Auslesen eines externen oder integrierten Referenzbauteils ermittelt.

Der Vergleich von Referenzwert und dem Wert des externen auslesbaren Bauteils erfolgt bevorzugt unter Zuhilfenahme eines Analog/Digital-Wandlers.

Das Auslesen der Werte des auslesbaren externen Bauteils sowie des Referenzbauteils erfolgt durch Beaufschlagen desselben mit einem von einer Signalquelle bereitgestellten Referenzsignal, bevorzugt während eines Einschaltvorgangs der integrierten Schaltungsanordnung.

Bevorzugt wird das Vergleichsergebnis nach dessen Ermittlung in einem flüchtigen Speicher zwischengespeichert, damit es auch nach dem Ende des Einschaltvorgangs bereitsteht.

Weiter bevorzugt wird der Vergleich während eines Einschaltvorgangs aktiviert und anschließend werden der Vergleicher, der den Vergleich durchführt und gegebenenfalls die Signalquelle, die zum Auslesen der auslesbaren Bauteilwerte dient, wieder deaktiviert.

Das von der Signalquelle bereitgestellte Referenzsignal kann beispielsweise eine Referenzspannung oder ein Referenzstrom sein.

Wenn bei der beschriebenen, integrierten Schaltungsanordnung ohnehin ein externer Filterkondensator oder ein ähnliches externes passives Bauteil vorgesehen ist, so kann dieses bevorzugt als Referenzbauteil verwendet werden. In diesem Fall sind zwei Pins vorgesehen, an denen das externe auslesbare Bauteil und das Referenzbauteil jeweils angeschlossen werden können. Das jeweils freie Ende derartiger passiver Bauteile wird bevorzugt mit einem Bezugspotentialanschluß, beispielsweise Masse, verbunden.

Das beschriebene Verfahren ermöglicht mit geringem Aufwand, daß in Abhängigkeit vom Wert eines an ein Pin der integrierten Schaltungsanordnung anschließbaren passiven Bauteils die integrierte Schaltungsanordnung in eine von mehreren vorbestimmten Betriebsarten versetzt werden kann.

Weitere Einzelheiten und vorteilhafte Ausgestaltungen des vorgeschlagenen Prinzips ergeben sich aus den Unteransprüchen.

Die Erfindung wird nachfolgend an mehreren Ausführungsbeispielen anhand von Zeichnungen näher erläutert.

Es zeigen:
- Figur 1: ein Ausführungsbeispiel einer integrierten Schaltungsanordnung mit zwei externen Widerständen,
- Figur 2: ein Ausführungsbeispiel einer erfindungsgemäßen, integrierten Schaltungsanordnung mit zwei externen Kapazitäten,
- Figur 3: ein Ausführungsbeispiel einer integrierten Schaltungsanordnung mit einem externen Widerstand und
- Figur 4: ein Ausführungsbeispiel einer erfindungsgemäßen, integrierten Schaltungsanordnung mit einer externen Kapazität.

In der folgenden Figurenbeschreibung sind gleiche oder gleich wirkende Bauteile mit gleichen Bezugszeichen versehen.

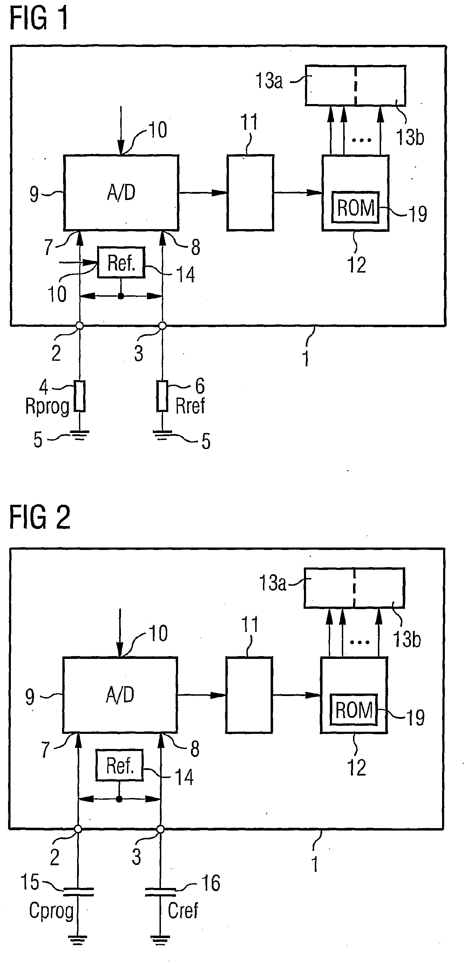

Figur 1 zeigt eine integrierte Schaltungsanordnung 1, welche unter anderem zwei Anschlüsse 2, 3 hat, sogenannte Pins. An den Anschluß 2 der integrierten Schaltungsanordnung 1 ist ein externes, auslesbares Bauteil in Form eines Widerstandes 4 gegen einen Bezugspotentialanschluß 5 angeschaltet. Der Widerstand 4 dient, wie später näher erläutert, zum Programmieren der Schaltungsanordnung 1. An den Anschluß 3 ist ein weiterer Widerstand 6, ebenfalls gegen Bezugspotentialanschluß 5, angeschaltet, der als Referenzbauteil dient. Die Anschlüsse 2, 3 der Schaltungsanordnung 1 sind intern mit einem ersten beziehungsweise einem zweiten Eingang 7, 8 eines Vergleichers 9 verbunden. Der Vergleicher 9 umfaßt einen Analog/Digital-Wandler. Der Vergleicher 9 hat einen Aktiviereingang 10 zum Aktivieren des Vergleichers 9 während einer Einschaltphase. An den Digitalausgang des A/D-Wandlers, der den Ausgang des Vergleichers 9 bildet, ist über einen flüchtigen Speicher 11 eine Steuereinheit 12 angeschlossen, welche mehrere Funktionsblöcke 13a, 13b in der Schaltungsanordnung 1 ansteuert.

Weiterhin ist eine Signalquelle 14 vorgesehen, welche ausgebildet ist zum Erzeugen eines Referenzsignals und welche mit den Anschlüssen 2, 3 der Schaltungsanordnung verbunden ist.

Das Referenzbauteil 6 dient nicht nur als Referenzbauteil für den Vergleicher 9 gemäß dem vorgeschlagenen Prinzip, sondern auch als Referenzwiderstand zum Erzeugen eines Bias-Signals, welches zur Funktion zumindest eines der Funktionsblöcke 13a, 13b ohnehin erforderlich ist.

Werden der Vergleicher 9 und die Signalquelle 14 mittels des Aktiviereingangs 10 in einer Einschaltphase der Schaltungsanordnung aktiviert, so werden der auslesbare, programmierende Widerstand 4 und der Referenzwiderstand 6 mit einem Referenzsignal beaufschlagt, das die Referenzquelle 14 erzeugt, also mit einer Referenzspannung oder einem Referenzstrom. Der Vergleicher 9 vergleicht die an seinen Eingängen 7, 8 sich einstellenden Signale, die natürlich von den Bauteilwerten Rprog, Rref der Widerstände 4, 6 abhängen, miteinander. Der A/D-Wandler bestimmt das Verhältnis der Werte Rprog, Rref der zwei externen Komponenten 4, 6 und gibt ein entsprechendes Vergleichsergebnis am Ausgang in digitaler Form aus. Dieses Vergleichsergebnis wird in dem Zwischenspeicher 11 zwischengespeichert. Anschließend werden der Vergleicher 9 mit dem A/D-Wandler und die Signalquelle 14 deaktiviert.

Mit dem im Speicher 11 gespeicherten Vergleichsergebnis ist es nun der Steuereinheit 12 möglich, die Funktionsblöcke 13a, 13b der Schaltungsanordnung anzusteuern. Dies erfolgt gemäß dem vorgeschlagenen Prinzip in Abhängigkeit vom Wert des programmierenden Widerstands 4.

Zur Durchführung des vorgeschlagenen Prinzips ist lediglich ein zusätzliches Pin 2 am Chip 1 erforderlich, da der Widerstand 6 am Pin 3 als Referenzwiderstand ohnehin erforderlich ist. Der zusätzliche Widerstand 4 kann ein einfacher und kostengünstiger externer Widerstand sein, an den geringe Toleranzanforderungen zu stellen sind. Durch Wahl der Größe des Widerstands des Widerstandsbauteils 4 können unterschiedliche Programmierungen beziehungsweise Betriebsarten der Schaltungkreise auf dem Chip 1 ausgewählt werden.

Eine weitere Verringerung der Anforderungen an die Toleranzgenauigkeit des Widerstands 4 ist dadurch erzielt, daß der A/D-Wandler im Vergleicher 9 eine logarithmische Kennlinie aufweist.

In der Steuereinheit 12 sind vorteilhafterweise für jeden einstellbaren Betriebsmodus eine Vielzahl von Parametern, wie z.B. Versorgungsspannungshöhen für bestimmte Funktionsblöcke 13a, 13b, Referenzspannungspegel, Einschaltreihenfolgen etc. in Boot-ROM abgelegt. Das Boot-ROM ist durch Variation der Metallisierung Masken-programmierbar ausgeführt. Dieses ROM wird vom Ergebnis des Vergleichers 9 adressiert. Die verfügbaren Einschaltsequenzen, von denen eine mit dem Widerstand 4 ausgewählt werden kann, werden demnach durch Metallisierungsmasken definiert und in der Anwendung durch den Wert des programmierenden Bausteins 4 ausgewählt.

Eine noch weitere Vergrößerung der Flexibilität kann dadurch erreicht werden, daß das ROM in der Steuereinheit 12 als programmierbares ROM ausgeführt ist und hierfür Zener- oder Polysilizium-Fuses aufweist.

Besonders vorteilhaft ist das beschriebene Prinzip anwendbar zur Steuerung der Einschaltsequenz in Spannungsversorgungseinheiten, englisch Power Management Units, PMU.

Figur 2 zeigt eine alternative Ausführungsform der integrierten Schaltungsanordnung von Figur 1. Die Schaltung von Figur 2 entspricht in ihrem Aufbau und in ihrer vorteilhaften Funktionsweise weitgehend derjenigen von Figur 1 und soll insoweit an dieser Stelle nicht noch einmal beschrieben werden. Anstelle des programmierenden Widerstands 4 und des Referenzwiderstands 6 ist bei der Schaltung von Figur 2 jedoch ein programmierender Kondensator 15 und eine Referenzkapazität 16 vorgesehen. Diese sind ebenfalls zwischen externe Anschlüsse 2, 3 des Chips 1 und Bezugspotential 5 geschaltet.

Der Referenzkondensator 16 ist am Chip 1 von Figur 2 ohnehin zum Betrieb wenigstens eines Funktionsblocks 13a, 13b als Filterkondensator vorgesehen.

Die Kondensatoren 15, 16 werden mittels der Signalquelle 14 bei Aktivierung des Vergleichers 9 und der Signalquelle 14 am Eingang 10 aufgeladen und die sich einstellenden Signale, die an Eingängen 7, 8 des Vergleichers 9 anliegen und von den Kapazitätswerten Cprog, Cref der Kondensatoren 15, 16 abhängig sind, werden von diesem ausgewertet. Die übrige Funktionsweise entspricht der in Figur 1 bereits erläuterten.

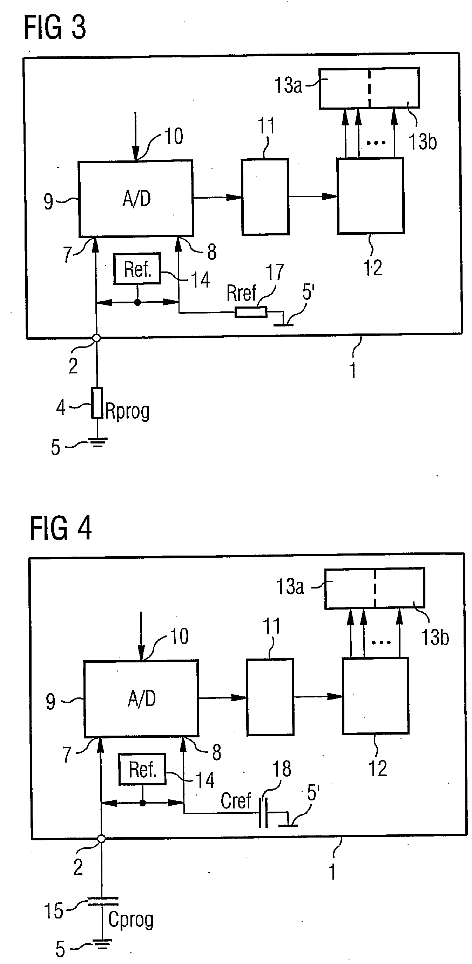

Figur 3 zeigt eine alternative Ausführungsform zu Figur 1, welche mit dieser in Aufbau und vorteilhafter Funktionsweise weitgehend übereinstimmt. Insoweit wird die Figurenbeschreibung an dieser Stelle nicht wiederholt. Bei dem Ausführungsbeispiel gemäß Figur 3 ist anstelle des externen Referenzwiderstands 6 ein integrierter Referenzwiderstand 17 vorgesehen, der zwischen den Eingang 8 des Vergleichers 9 und einen internen Bezugspotentialanschluß 5' geschaltet ist. Dadurch entfällt das externe Anschlußpin 3 am Chip 1.

Das beschriebene Ausführungsbeispiel hat den Vorteil, daß weniger Anschlußpins am Chip erforderlich sind und kommt beispielsweise dann bevorzugt zur Anwendung, wenn nicht ohnehin ein externes Referenzbauteil erforderlich ist, beispielsweise zur Erzeugung eines präzisen Referenzsignals oder als Filterbauteil.

Figur 4 zeigt eine alternative Ausführungsform der Schaltung von Figur 2. Anstelle des externen Referenzkondensators 16 von Figur 2 ist bei der Schaltung von Figur 4 eine integrierte Kapazität 18 vorgesehen. Der Kondensator 18 ist zwischen den Eingang 8 des Vergleichers 9 und Bezugspotential 5' geschaltet.

Wie bei Figur 3 entfällt ein Anschlußpin, nämlich der Anschluß 3. Die gezeigte Ausführung kommt vorteilhaft zur Anwendung, wenn nicht ohnehin ein externer Filterkondensator als Referenzbauteil nötig ist.

Falls die Referenzbauteile 17, 18 von Figuren 3, 4 großen Fertigungsschwankungen bezüglich ihres Bauteilwertes unterworfen sind, kann es vorteilhaft sein, eine Abgleichmöglichkeit vorzusehen zum Abgleich des jeweiligen internen, passiven Referenzbauteils 17, 18.

Anstelle der in den Ausführungsbeispielen gezeigten Widerstände und Kapazitäten als Referenzbauteil und als programmierendes, auslesebares Bauteil können auch andere, passive Bauteile vorgesehen sein.

Die vorhergehende Beschreibung der Ausführungsbeispiele gemäß der vorliegenden Erfindung dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihre Äquivalente zu verlassen.

## Patentansprüche

1. Integrierte Schaltungsanordnung (1), aufweisend
- einen Vergleicher (9) mit einem ersten Eingang (7), der mit einem Anschluß (2) der integrierten Schaltungsanordnung verbunden ist, ausgelegt zum Anschließen eines externen, auslesbaren, als Kondensator ausgebildeten Bauteils (15) mit einem Wert (Cprog) aus einer vorbestimmten Wertemenge, mit einem zweiten Eingang (8), an dem ein auslesbares Referenzbauteil (16, 18) angeschlossen ist, welches ein ohnehin zum Betrieb wenigstens eines Funktionsblocks als Filterkondensator vorgesehener, externer Referenzkondensator, oder eine integrierte Kapazität ist, und mit einem Ausgang,
- die Schaltungsanordnung (1) weiter aufweisend eine Steuereinheit (12), die mit dem Ausgang des Vergleichers (9) gekoppelt ist zum Steuern der integrierten Schaltungsanordnung (1) in Abhängigkeit von einem Vergleichsergebnis des Vergleichers (9), wobei
- eine Signalquelle (14) zum Erzeugen eines Referenzsignals vorgesehen ist, die mit dem Anschluß (2) zum Anschließen eines externen, auslesbaren Bauteils (15) und mit dem Referenzbauteil (16, 18) gekoppelt ist zum Auslesen des jeweiligen Bauteilwertes (Cprog, Cref).

2. Schaltungsanordnung nach Anspruch 1,
**dadurch gekennzeichnet, daß**
das externe, auslesbare Bauteil (15) an einem weiteren Anschluß mit einem Bezugspotentialanschluß (5) gekoppelt ist.

3. Schaltungsanordnung nach einem der Ansprüche 1 bis 2,
**dadurch gekennzeichnet, daß**
der Vergleicher (9) einen Analog/Digital-Wandler zur Abgabe des Vergleichsergebnisses in digitaler Form umfaßt.

4. Schaltungsanordnung nach Anspruch 3,
**dadurch gekennzeichnet, daß**
der Analog/Digital-Wandler eine logarithmische Kennlinie hat.

5. Schaltungsanordnung nach einem der Ansprüche 1 bis 4, **da**
**durch gekennzeichnet,** daß
das Referenzbauteil als externes Bauteil (16) an einem weiteren Anschluß (3) der integrierten Schaltungsanordnung (1) anschließbar ist.

6. Schaltungsanordnung nach einem der Ansprüche 1 bis 4, **da**
**durch gekennzeichnet,** daß
das Referenzbauteil als integriertes Bauteil (18) der integrierten Schaltungsanordnung (1) vorgesehen ist.

7. Schaltungsanordnung nach einem der Ansprüche 1 bis 6, **da**
**durch gekennzeichnet,** daß
mehrere Funktionsblöcke (13a, 13b) vorgesehen sind, die bezüglich Versorgungsspannung, Referenzspannung und/oder Einschaltreihenfolge von der Steuereinheit (12) angesteuert werden.

8. Schaltungsanordnung nach einem der Ansprüche 1 bis 7, **da**
**durch gekennzeichnet,** daß
ein flüchtiger Speicher (11) zwischen den Ausgang des Vergleichers (9) und die Steuereinheit (12) geschaltet ist zum Zwischenspeichern des Vergleichsergebnisses des Vergleichers (9).

9. Schaltungsanordnung nach einem der Ansprüche 1 bis 8, **da**
**durch gekennzeichnet,** daß
ein Speicherblock (19) zum Ablegen von Steuerungsparametern zu mehreren Betriebsarten des zumindest einen Funktionsblocks (13a, 13b) der Schaltungsanordnung (1) vorgesehen ist, der mit der Steuereinheit (12) gekoppelt oder von dieser umfaßt ist, wobei in Abhängigkeit von dem Vergleichsergebnis des Vergleichers (9) eine der gespeicherten Betriebsarten aktiviert wird.

10. Schaltungsanordnung nach einem der Ansprüche 1 bis 9, **da**
**durch gekennzeichnet,** daß
der Vergleicher (9) einen Aktivierungseingang (10) hat zum Aktivieren des Vergleichers (9) nach einem Einschalten des integrierten Schaltkreises (1).

11. Verfahren zur Programmierung einer integrierten Schaltungsanordnung, umfassend folgende Verfahrensschritte:
- Auslesen eines Wertes (Cprog) eines externen, als Kondensator ausgebildeten und an der integrierten Schaltungsanordnung angeschlossenen Bauteils (15),
- Vergleich des ausgelesenen Wertes (Cprog) mit einem Referenzwert (Cref) eines Referenzbauteils, welches ein ohnehin zum Betrieb wenigstens eines Funktionsblocks als Filterkondensator vorgesehener, externer Referenzkondensator, oder eine integrierte Kapazität ist, und Ermittlung eines Vergleichsergebnisses,
- Abgeben eines Auswahlsignals zur Steuerung der integrierten Schaltungsanordnung (1) in Abhängigkeit vom Vergleichsergebnis,
- bei dem der Wert (Cprog) des externen, an der integrierten Schaltungsanordnung angeschlossenen Bauteils (15) durch Beaufschlagen des Bauteils mit einem Referenzsignal ausgelesen wird und
- bei dem der Referenzwert (Cref) durch den Wert eines Referenzbauteils (16, 18) repräsentiert wird, der ebenfalls durch Beaufschlagen mit dem Referenzsignal ausgelesen wird.

12. Verfahren nach Anspruch 11,
bei dem die Schaltungsanordnung (1) in Abhängigkeit vom Auswahlsignal in einen vorbestimmten Betriebszustand aus einer Menge von vorbestimmten Betriebszuständen versetzt wird.

13. Verfahren nach einem der Ansprüche 11bis 12,
bei dem das Vergleichsergebnis während eines Einschaltvorgangs der integrierten Schaltungsanordnung ermittelt und in einem flüchtigen Speicher (11) zwischengespeichert wird.

## Claims

1. Integrated circuit arrangement (1), comprising
- a comparator (9) having a first input (7) in communication with a terminal (2) of the integrated circuit arrangement, designed for connecting an external, readable component (15) that is formed as a capacitor having a value (Cprog) out of a predetermined value set, having a second input (8) to which a readable reference component (16, 18) is connected which is an external reference capacitor anyway provided for operating at least one functional block as a filter capacitor, or an integrated capacity, and having an output,
- the circuit arrangement (1) further comprising a control unit (12) coupled to the output of the comparator (9) for controlling the integrated circuit arrangement (1) as a function of a comparison result of the comparator, wherein
- a signal source (14) for generating a reference signal is provided which is coupled to the terminal (2) for connecting an external readable component (15) and to the reference component (16, 18) for reading the respective component value (Cprog, Cref).

2. Circuit arrangement according to claim 1,
**characterized in that**
the external readable component (15) is coupled to a further terminal by a reference potential terminal (5).

3. Circuit arrangement according to any one of claims 1 to 2,
**characterized in that**
the comparator (9) comprises an analog-to-digital converter for outputting the comparison result in a digital form.

4. Circuit arrangement according to claim 3,
**characterized in that**
the analog-to-digital converter has a logarithmic characteristic.

5. Circuit arrangement according to any one of claims 1 to 4,
**characterized in that**
the reference component as an external component (16) can be connected to a further terminal (3) of the integrated circuit arrangement (1).

6. Circuit arrangement according to any one of claims 1 to 4,
**characterized in that**
the reference component is provided as an integrated component (18) of the integrated circuit arrangement (1).

7. Circuit arrangement according to any one of claims 1 to 6,
**characterized in that**
several functional blocks (13a, 13b) are provided which are controlled by the control unit (12) with respect to supply voltage, reference voltage and/or switch-on sequence.

8. Circuit arrangement according to any one of claims 1 to 7,
**characterized in that**
a volatile memory (11) is connected between the comparator's (9) output and the control unit (12) for buffering the comparator's (9) comparison result.

9. Circuit arrangement according to any one of claims 1 to 8,
**characterized in that**
a memory block (19) for storing control parameters to several operating modes of the at least one functional block (13a, 13b) of the circuit arrangement (1) is provided which is coupled to or comprised by the control unit (12), wherein one of the stored operating modes is activated as a function of the comparator's (9) comparison result.

10. Circuit arrangement according to any one of claims 1 to 9,
**characterized in that**
the comparator (9) has a activating input (10) for activating the comparator (9) after switching on the integrated circuit (1).

11. Method for programming an integrated circuit arrangement, comprising the following process steps:
- reading a value (Cprog) of an external component (15) that is formed as a capacitor and connected to the integrated circuit arrangement,
- comparing the read value (Cprog) to a reference value (Cref) of a reference component which is an external reference capacitor anyway provided for operating at least one functional block as a filter capacitor, or an integrated capacity, and determining a comparison result,
- outputting a selection signal for controlling the integrated circuit arrangement (1) as a function of the comparison result,
- in which the value (Cprog) of the external component (15) that is connected to the integrated circuit arrangement is read by applying a reference signal to the component, and
- in which the reference value (Cref) is representd by the value of a reference component (16, 18) which is likewise read by applying the reference signal.

12. Method according to claim 11,
in which the circuit arrangement (1) is put into a predetermined operating state out of a multitude of operating states as a function of the selection signal.

13. Method according to any one of claims 11 to 12,
in which the comparison result is determined durig a switch-on operation of the integrated circuit arrangement and buffered in a volatile memory (11).

## Revendications

1. Agencement de circuit (1) intégré, présentant
- un comparateur (9) doté d'une première entrée (7) qui est reliée à une connexion (2) de l'agencement de circuit intégré, conçu pour la connexion d'un composant (15) externe lisible constitué comme condensateur avec une valeur (Cprog) issue d'une quantité de valeurs prédéterminée, doté d'une deuxième entrée (8) à laquelle un composant de référence (16, 18) lisible est connecté, lequel est un condensateur de référence externe de toute façon prévu comme condensateur de filtrage pour le fonctionnement d'au moins un bloc fonctionnel, ou une capacité intégrée, et doté d'une sortie,
- l'agencement de circuit (1) présentant en outre une unité de commande (12) qui est couplée à la sortie du comparateur (9) pour la commande de l'agencement de circuit (1) intégré en fonction d'un résultat de comparaison du comparateur (9), sachant que
- une source de signal (14) destinée à générer un signal de référence est prévue, laquelle est couplée à la connexion (2) destinée à connecter un composant (15) externe lisible et au composant de référence (16, 18) pour la lecture de la valeur de composant respective (Cprog, Cref).

2. Agencement de circuit selon la revendication 1,
**caractérisé en ce que**
le composant (15) externe lisible est couplé à une connexion de potentiel de référence (5) via une connexion supplémentaire.

3. Agencement de circuit selon l'une des revendications 1 à 2,
**caractérisé en ce que**
le comparateur (9) comprend un convertisseur analogique-numérique destiné à délivrer le résultat de comparaison sous forme numérique.

4. Agencement de circuit selon la revendication 3,
**caractérisé en ce que**
le convertisseur analogique-numérique a une courbe caractéristique logarithmique.

5. Agencement de circuit selon l'une des revendications 1 à 4,
**caractérisé en ce que**
le composant de référence est apte à être connecté comme composant (16) externe au niveau d'une connexion (3) supplémentaire de l'agencement de circuit (1) intégré.

6. Agencement de circuit selon l'une des revendications 1 à 4,
**caractérisé en ce que**
le composant de référence est prévu comme composant intégré (18) de l'agencement de circuit (1) intégré.

7. Agencement de circuit selon l'une des revendications 1 à 6,
**caractérisé en ce que**
plusieurs blocs fonctionnels (13a, 13b) sont prévus, lesquels sont pilotés par l'unité de commande (12) en matière de tension d'alimentation, de tension de référence et/ou de séquence de mise en marche.

8. Agencement de circuit selon l'une des revendications 1 à 7,
**caractérisé en ce que**
une mémoire volatile (11) est montée entre la sortie du comparateur (9) et l'unité de commande (12) pour la mise en mémoire tampon du résultat de comparaison du comparateur (9).

9. Agencement de circuit selon l'une des revendications 1 à 8,
**caractérisé en ce que**
un bloc mémoire (19) destiné à classer des paramètres de commande selon plusieurs modes de fonctionnement de l'au moins un bloc fonctionnel (13a, 13b) de l'agencement de circuit (1) est prévu, lequel est couplé à l'unité de commande (12) ou inclus par celle-ci, sachant qu'en fonction du résultat de comparaison du comparateur (9), l'un des modes de fonctionnement mémorisés est activé.

10. Agencement de circuit selon l'une des revendications 1 à 9,
**caractérisé en ce que**
le comparateur (9) présente une entrée d'activation (10) destinée à activer le comparateur (9) après la mise en marche du circuit (1) intégré.

11. Procédé de programmation d'un agencement de circuit intégré, comprenant les étapes de procédé suivantes:
- lecture d'une valeur (Cprog) d'un composant (15) externe constitué comme condensateur et connecté à l'agencement de circuit intégré,
- comparaison de la valeur (Cprog) lue avec une valeur de référence (Cref) d'un composant de référence, lequel est un condensateur de référence externe de toute façon prévu comme condensateur de filtrage pour le fonctionnement d'au moins un bloc fonctionnel, ou une capacité intégrée, et détermination d'un résultat de comparaison,
- délivrance d'un signal de sélection pour la commande de l'agencement de circuit (1) intégré en fonction du résultat de comparaison,
- dans lequel la valeur (Cprog) du composant (15) externe connecté à l'agencement de circuit intégré est lue par application d'un signal de référence au composant et
- dans lequel la valeur de référence (Cref) est représentée par la valeur d'un composant de référence (16, 18) qui est également lue par application du signal de référence.

12. Procédé selon la revendication 11,
dans lequel l'agencement de circuit (1) est mis dans un état de fonctionnement prédéterminé issu d'une quantité d'états de fonctionnement prédéterminés en fonction du signal de sélection.

13. Procédé selon l'une des revendications 11 à 12,
dans lequel le résultat de comparaison est déterminé pendant une opération de mise en marche de l'agencement de circuit intégré et mis en mémoire tampon dans une mémoire volatile (11).
